# EUROPEAN PATENT APPLICATION

(11) **EP 4 679 981 A2**
(43) Date of publication of application: **14.01.2026**
(21) Application number: 25218825.5
(22) Date of filing: 26.11.2025
(51) Int. Cl.: H10F 77/20, H10F 10/16, H10F 10/166, H10F 71/00, H10F 71/10, H10F 77/30, H10F 77/70, H10F 19/40

(54) **BACK CONTACT SOLAR CELL AND MANUFACTURING METHODS THEREOF, TANDEM SOLAR CELL, AND PHOTOVOLTAIC MODULE**

(30) Priority: 28.07.2025 CN 202511046833
(71) Applicant: Jinko Solar (Haining) Co., Ltd., Haining City, Zhejiang 314415 (CN)
(72) Inventor: XIONG, Qiwu, Haining, 314415 (CN); SUN, Yufeng, Haining, 314415 (CN); DUAN, Weiyuan, Haining, 314415 (CN); YANG, Jie, Haining, 314415 (CN); ZHANG, Xinyu, Haining, 314415 (CN)
(74) Representative: Haseltine Lake Kempner LLP

(57) **Abstract**

A back contact solar cell and a manufacturing method thereof, a tandem solar cell, and a photovoltaic module are provided. The back contact solar cell includes: a substrate having first and second surfaces opposite to each other, the second surface including first and second regions alternately arranged; a tunneling layer located on the first region; a first doped semiconductor layer located on a surface of the tunneling layer; a first transparent conductive layer located on a surface of the first doped semiconductor layer, a surface of the first transparent conductive layer away from the substrate provided with particles; an amorphous silicon layer located on the second region; a second doped semiconductor layer located on a surface of the amorphous silicon layer; and a second transparent conductive layer located on a surface of the second doped semiconductor layer, a gap being present between the first and second transparent conductive layers.

## Description

### TECHNICAL FIELD

The present disclosure relates to the photovoltaic field, and in particular, to a back contact solar cell and a manufacturing method thereof, a tandem solar cell, and a photovoltaic module.

### BACKGROUND

With the gradual depletion of fossil energy, photovoltaic cells, as a new energy alternative, are increasingly widely used. Photovoltaic cells are devices that convert solar energy into electrical energy, utilizing the photovoltaic effect to generate charge carriers, which are then extracted through electrodes, thereby facilitating the effective utilization of electrical energy. To further reduce the shading of the front surface of the photovoltaic cells by grid lines, research on back contact solar cells (BC solar cells) has become more in-depth.

However, when different types of passivation contact structures are constructed on different regions of the back surface of BC solar cells to enhance the photoelectric conversion efficiency of BC solar cells, the absorption and utilization of light, as well as the collection efficiency of accumulated carriers by subsequent electrodes, vary over the different passivation contact structures on the different regions. Based on this, further research on BC solar cells is needed to compensate for the impact of the above differences on their photoelectric conversion efficiency.

### SUMMARY

Embodiments of the present disclosure provide a back contact solar cell and a manufacturing method thereof, a tandem solar cell, and a photovoltaic module, which is at least conducive to improving the light-trapping effect and carrier collection efficiency of the back contact solar cell.

According to some embodiments of the present disclosure, in one aspect of the embodiments of the present disclosure, a back contact solar cell is provided, including: a substrate having a first surface and a second surface opposite to each other in a first direction, the second surface including a first region and a second region alternately arranged in a second direction; a tunneling layer, at least located on the first region; a first doped semiconductor layer located on a surface of the tunneling layer away from the substrate; a first transparent conductive layer, located on a surface of the first doped semiconductor layer away from the substrate, a surface of the first transparent conductive layer away from the substrate being provided with a plurality of particles; an amorphous silicon layer, at least located on the second region; a second doped semiconductor layer, located on a surface of the amorphous silicon layer away from the substrate; and a second transparent conductive layer, located on a surface of the second doped semiconductor layer away from the substrate, a gap being present between the second transparent conductive layer and the first transparent conductive layer.

In some embodiments, the particles have a size of 1 µm to 4 µm.

In some embodiments, the particles have a distribution density of 2.5 X 10⁶ /cm² to 4.5 × 10⁶ /cm².

In some embodiments, the first region is a polished surface, and the second region is a textured surface.

In some embodiments, a material of the particles is the same as a material of the first transparent conductive layer. Alternatively, the material of the particles includes at least one of silicon oxide, titanium oxide, zinc oxide, or silver nanoparticles, and the material of the first transparent conductive layer includes at least one of tin-doped indium oxide, tungsten-doped indium oxide, cesium-doped indium oxide, cerium-doped indium oxide, tin oxide, gallium-doped zinc oxide, aluminum-doped zinc oxide, or aluminum zinc oxide.

In some embodiments, the back contact solar cell further includes a protective layer, located on a surface of the first transparent conductive layer away from the substrate.

In some embodiments, in the first direction, a thickness of the first transparent conductive layer is greater than a thickness of the second transparent conductive layer.

In some embodiments, both the first doped semiconductor layer and the substrate are doped with a first doping element, and the second doped semiconductor layer is doped with a second doping element, a doping type of the first doping element being different from a doping type of the second doping element; and/or a material of the first doped semiconductor layer includes doped polysilicon, and a material of the second doped semiconductor layer includes doped amorphous silicon.

According to some embodiments of the present disclosure, in another aspect of the embodiments of the present disclosure, a method for manufacturing a back contact solar cell is provided, including: providing a substrate, the substrate having a first surface and a second surface opposite to each other in a first direction, the second surface including a first region and a second region alternately arranged in a second direction; forming a tunneling layer and a first doped semiconductor layer at least on the first region, the first doped semiconductor layer being located on a surface of the tunneling layer away from the substrate; forming an amorphous silicon layer and a second doped semiconductor layer at least on the second region, the second doped semiconductor layer being located on a surface of the tunneling layer away from the substrate; and forming a first transparent conductive layer and a second transparent conductive layer; wherein the first transparent conductive layer is located on a surface of the first doped semiconductor layer away from the substrate, a surface of the first transparent conductive layer away from the substrate is provided with a plurality of particles, the second transparent conductive layer is located on a surface of the second doped semiconductor layer away from the substrate, and a gap is present between the second transparent conductive layer and the first transparent conductive layer.

In some embodiments, the step of forming the first transparent conductive layer and the second transparent conductive layer includes: forming an initial transparent conductive layer located both on a surface of the first doped semiconductor layer located on the first region away from the substrate and on a surface of the second doped semiconductor layer located on the second region away from the substrate; performing a grooving process on the initial transparent conductive layer to form a gap between the initial transparent conductive layer located on the first region and the initial transparent conductive layer located on the second region; and performing a laser treatment on the initial transparent conductive layer located on the first region to form the particles on the surface of the initial transparent conductive layer located on the first region away from the substrate.

In some embodiments, a laser used in the laser treatment has a wavelength of 355 nm to 532 nm.

In some embodiments, the step of forming the first transparent conductive layer includes forming an initial first transparent conductive layer on the surface of the first doped semiconductor layer located on the first region away from the substrate; and etching the surface of the initial first transparent conductive layer away from the substrate to form the first transparent conductive layer with the particles.

In some embodiments, the step of forming the first transparent conductive layer includes: forming an initial first transparent conductive layer on the surface of the first doped semiconductor layer located on the first region away from the substrate; and forming the particles on a surface of the initial first transparent conductive layer away from the substrate, wherein the particles are located on the surface of the initial first transparent conductive layer away from the substrate, or a portion of the particles are embedded in the initial first transparent conductive layer, and the particles and the initial first transparent conductive layer collectively constitute the first transparent conductive layer.

According to some embodiments of the present disclosure, in yet another aspect of the embodiments of the present disclosure, a tandem solar cell is further provided, including: a bottom solar cell, the bottom solar cell being the back contact solar cell according to any one of the above embodiments, or a back contact solar cell formed by the method as described in any one of the above embodiments; and a top solar cell located on a side of the bottom solar cell.

According to some embodiments of the present disclosure, in still another aspect of the embodiments of the present disclosure, a photovoltaic module is further provided, including: a solar cell string, formed by electrically connecting a plurality of the back contact solar cells according to any one of the above embodiments, or formed by electrically connecting a plurality of back contact solar cells formed by the method for manufacturing a back contact solar cell according to any one of the above embodiments, or formed by electrically connecting a plurality of the tandem solar cells as described above; an encapsulation adhesive film configured to cover a surface of the solar cell string; and a cover plate configured to cover a surface of the encapsulation adhesive film away from the solar cell string.

The technical solutions provided in the embodiments of the present disclosure have at least the following advantages:
Based on the construction of two passivation contact structures of significantly different materials on the first and second regions of the second surface, the surface of the first transparent conductive layer on the first region away from the substrate is provided with a plurality of particles. With the particles, this configuration is conducive to enhancing the light-trapping effect of the first transparent conductive layer, allowing more light to irradiate the first region and to be absorbed and utilized, and thereby generating more photogenerated carriers. Meanwhile, with the particles, this configuration is conducive to increasing the contact area between a subsequent electrode and the first transparent conductive layer, which reduces the contact resistance therebetween, thereby facilitating improvement of carrier collection efficiency by the electrode. As such, multi-faceted collaboration is conducive to compensating for the differences in photoelectric conversion efficiency between the local back contact solar cells corresponding to the first and second regions respectively, thereby enhancing the overall photoelectric conversion efficiency of the back contact solar cell.

Additionally, with the particles, this configuration is conducive to increasing the adhesion between the subsequent electrode and the first transparent conductive layer, thereby improving their bonding strength and enhancing the structural stability of the back contact solar cell.

### BRIEF DESCRIPTION OF THE DRAWINGS

One or more embodiments are exemplarily described with reference to the corresponding figures in the accompanying drawings, and the exemplary descriptions are not to be construed as limiting the embodiments. Unless otherwise particularly stated, the figures in the accompanying drawings are not drawn to scale. In order to more clearly illustrate the technical solutions in embodiments of the present disclosure or the conventional art, the accompanying drawings used in the description of the embodiments will be briefly introduced below. It is apparent that, the accompanying drawings in the following description are only some embodiments of the present disclosure, and other drawings can be obtained by those of ordinary skill in the art from the provided drawings without creative efforts.
FIG. 1 is a schematic partial cross-sectional view of a back contact solar cell according to an embodiment of the present disclosure.
FIG. 2 shows a scanning electron microscope (SEM) image of a first transparent conductive layer of a back contact solar cell according to an embodiment of the present disclosure.
FIG. 3 is schematic partial cross-sectional view of a back contact solar cell according to another embodiment of the present disclosure.
FIG. 4 is schematic partial cross-sectional view of a back contact solar cell according to yet another embodiment of the present disclosure.
FIG. 5 is schematic partial cross-sectional view of a back contact solar cell according to still another embodiment of the present disclosure.
FIG. 6 is a schematic partial cross-sectional view of a back contact solar cell after forming an initial transparent conductive layer in a manufacturing method thereof according to another embodiment of the present disclosure.
FIG. 7 is a schematic partial cross-sectional view of a back contact solar cell after performing a grooving process in a manufacturing method thereof according to another embodiment of the present disclosure.
FIG. 8 is a schematic partial cross-sectional view of a back contact solar cell after forming an initial first transparent conductive layer in a manufacturing method thereof according to another embodiment of the present disclosure.
FIG. 9 is a schematic partial cross-sectional view of a tandem solar cell according to yet another embodiment of the present disclosure.
FIG. 10 is a schematic partial three-dimensional view of a solar cell string in a photovoltaic module according to still another embodiment of the present disclosure.
FIG. 11 is a schematic partial cross-sectional view of a photovoltaic module according to still another embodiment of the present disclosure.

Reference signs:
100: substrate; 110: first surface; 120: second surface; 1201: first region; 1202: second region; 101: tunneling layer; 102: first doped semiconductor layer; 103: first transparent conductive layer; 113: particles; 123: initial first transparent conductive layer; 104: amorphous silicon layer; 105: second doped semiconductor layer; 106: second transparent conductive layer; 136: initial transparent conductive layer; 107: protective layer; 117: front surface passivation layer; 108: bottom solar cell; 118: first electrode; 128: second electrode; 109: top solar cell; 40: back contact solar cell; 41: encapsulation adhesive film; 42: cover plate; 43: conductive strip.

### DETAILED DESCRIPTION

As can be seen from the background, the photoelectric conversion efficiency of the back contact solar cell is needed to be further improved.

Embodiments of the present disclosure provide a back contact solar cell and a manufacturing method thereof, a tandem solar cell, and a photovoltaic module. In the back contact solar cell, based on the construction of two passivation contact structures of significantly different materials on the first and second regions of the second surface, the surface of the first transparent conductive layer on the first region away from the substrate is provided with a plurality of particles. with the particles, this configuration is conducive to enhancing the light-trapping effect of the first transparent conductive layer, allowing more light to irradiate the first region and to be absorbed and utilized, and thereby generating more photogenerated carriers. Meanwhile, with the particles, this configuration is conducive to increasing the contact area between a subsequent electrode and the first transparent conductive layer, which reduces the contact resistance therebetween, thereby facilitating improvement of carrier collection efficiency by the electrode. As such, multi-faceted collaboration is conducive to compensating for the differences in photoelectric conversion efficiency between the local back contact solar cells corresponding to the first and second regions respectively, thereby enhancing the overall photoelectric conversion efficiency of the back contact solar cell. Additionally, with the particles, this configuration is conducive to increasing the adhesion between the subsequent electrode and the first transparent conductive layer, thereby improving their bonding strength and enhancing the structural stability of the back contact solar cell.

In the description of the embodiments of the present disclosure, the technical terms "first", "second", and the like are merely intended to distinguish different objects, and cannot be understood as an indication or implication of relative importance or implicit indication of the number, specific sequence, or dominant-subordinate relationship of the technical features indicated. In the description of the embodiments of the present disclosure, "a plurality of" means two or more, unless otherwise specifically stated.

The term "embodiment" described herein means that specific features, structures, or characteristics described in combination with the embodiments may be incorporated in at least one embodiment of the present disclosure. Phrases appearing at various positions of the specification refer to neither the same embodiment nor separate or alternative embodiments that are mutually exclusive with other embodiments. It is explicitly and implicitly understood by those skilled in the art that the embodiments described herein may be combined with other embodiments.

In the description of the embodiments of the present disclosure, the term "and/or" herein is merely an association relationship describing associated objects, indicating that three relationships may exist. For example, A and/or B indicates that there are three cases of A alone, A and B together, and B alone. In addition, the character "/" herein generally indicates an "or" relationship between the associated objects.

In the description of the embodiments of the present disclosure, the term "a plurality of" means more than two (including two). Similarly, "a plurality of groups" means more than two groups (including two), and "a plurality of pieces" means more than two pieces (including two).

In the description of the embodiments of the present disclosure, the orientation or position relationships indicated by the technical terms "central", "longitudinal", "transverse", "length", "width", "thickness", "upper", "lower", "front", "back", "left", "right", "vertical", "horizontal", "top", "bottom", "inner", "outer", "clockwise", "counterclockwise", "axial", "radial", "circumferential", and the like are based on the orientation or position relationships shown in the accompanying drawings and are intended to facilitate the description of the present disclosure and simplify the description only, rather than indicating or implying that the apparatus or element referred to must have a particular orientation or be constructed and operated in a particular orientation, and therefore are not to be interpreted as limiting the embodiments of the present disclosure.

In the description of the embodiments of the present disclosure, unless otherwise specified and defined explicitly, the technical terms "mount", "connect", "join", and "fix" should be understood in a broad sense, which may be, for example, a fixed connection, a detachable connection, or an integral connection; a mechanical connection or an electrical connection; or a direct connection, an indirect connection via an intermediate medium, an internal communication between two elements, or interaction between two elements. Those of ordinary skill in the art can understand specific meanings of these terms in the embodiments of the present disclosure according to specific situations.

In the drawings corresponding to the embodiments of the present disclosure, for better understanding and ease of description, a thickness and an area of a layer are exaggerated. When a component (such as a layer, film, region, or substrate) is described as being on another component or on a surface of another component, the component may be "directly" on the surface of the other component or there may be a third component between the two components.

In the description of the embodiments of the present disclosure, when a component "includes" or "comprises" another component, other components are not excluded and may further be included unless otherwise stated. In addition, when a component such as a layer, a film, a region, or a plate is referred to as being "on/located on" another component, it may be "directly on" the other component (i.e., on a surface of the other component without other components therebetween), or another component may exist therebetween. In addition, when a component such as a layer, a film, a region, or a plate is "directly on" another component, or when a component such as a layer, a film, a region, or a plate is on a surface of another component, it means that no other components exist therebetween.

The terms used in the description of the embodiments herein are for describing particular embodiments only and not intended to be limiting. As used in the description of the embodiments and in the appended claims, "component" is also intended to include the plural form unless the context clearly indicates otherwise. The component includes a layer, a film, a region, a plate, or the like.

Various embodiments of the present disclosure will be described in detail below with reference to the accompanying drawings. However, those of ordinary skill in the art may understand that in the embodiments of the present disclosure, many technical details are provided to enable readers to better understand the embodiments of the present disclosure. However, even without these technical details and various changes and modifications based on the following embodiments, the technical solutions in the embodiments of the present disclosure can still be implemented.

An embodiment of the present disclosure provides a back contact solar cell. The back contact solar cell provided in an embodiment of the present disclosure will be described in detail below with reference to the accompanying drawings.

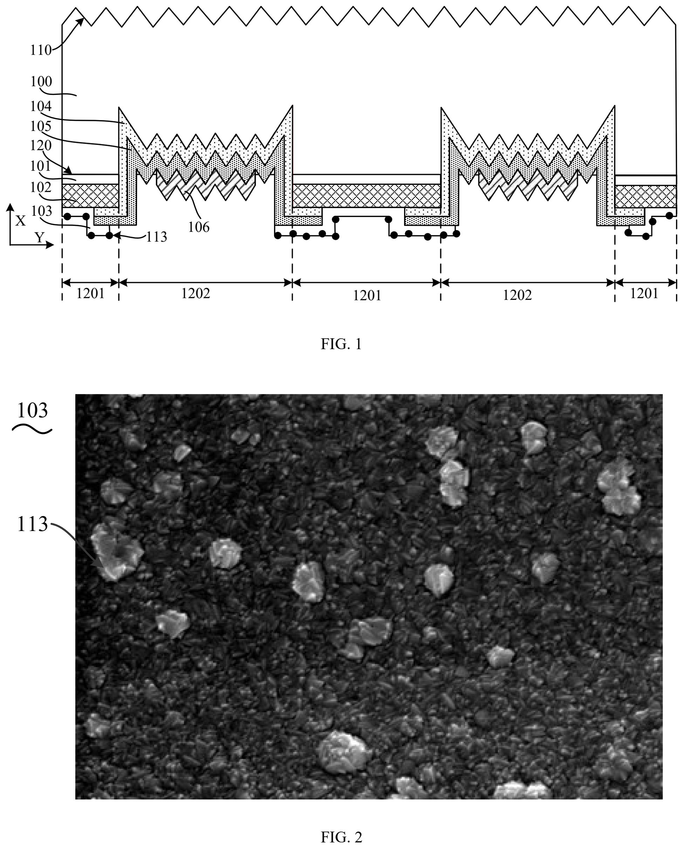

Referring to FIG. 1, the back contact solar cell includes: a substrate 100 having a first surface 110 and a second surface 120 opposite to each other in a first direction X, wherein the second surface 120 includes a first region 1201 and a second region 1202 alternately arranged in a second direction Y; a tunneling layer 101, at least located on the first region 1201; a first doped semiconductor layer 102, located on a surface of the tunneling layer 101 away from the substrate 100; a first transparent conductive layer 103, located on a surface of the first doped semiconductor layer 102 away from the substrate 100, wherein a surface of the first transparent conductive layer 103 away from the substrate 100 is provided with a plurality of particles 113; an amorphous silicon layer 104, at least located on the second region 1202; a second doped semiconductor layer 105, located on a surface of the amorphous silicon layer 104 away from the substrate 100; and a second transparent conductive layer 106, located on a surface of the second doped semiconductor layer 105 away from the substrate 100, wherein a gap is present between the second transparent conductive layer 106 and the first transparent conductive layer 103.

It should to be noted that FIG. 1 is a schematic partial cross-sectional view of a back contact solar cell according to an embodiment of the present disclosure, and FIG. 2 shows a scanning electron microscope (SEM) image of a first transparent conductive layer of a back contact solar cell according to an embodiment of the present disclosure.

Furthermore, in FIG. 1, a plurality of particles 113 on the surface of the first transparent conductive layer 103 away from the substrate 100 are schematically represented as black dots. In practical applications, the particles may be spherical particles or particles that possess other regular or irregular morphologies. In other words, the surface morphology of the particles exhibits a stochastic nature, with their cross-sectional profiles along any section approximating circular, elliptical, N-gon (where N is a positive integer greater than or equal to 3), or irregular geometries. In some embodiments, the particles function as light-trapping structures and thus can also be referred to as light-trapping particles. It can be understood that the particles can modify the propagation path of incident light by promoting light scattering, thereby reducing light reflection and enhancing light absorption to achieve the light-trapping function.

It should be noted that the particles represented by black dots in FIG. 1 may also correspond to recessed structures extending toward the substrate, such as pits or holes. Therefore, in some embodiments, the surface of the first transparent conductive layer away from the substrate may be provided with a plurality of recessed structures extending toward the substrate. In these cases, the shape of the recessed structures is defined by the wall surfaces forming them, while size of the recessed structures corresponds to those of particles whose shapes match the defined shapes. In addition, the parameters used herein to describe particles also apply to recessed structures such as pits or holes that match the particle shape. It can be understood that the recessed structures can also modify the propagation path of incident light by promoting light scattering, thereby reducing light reflection and enhancing light absorption to achieve the light-trapping function.

The off-white particles shown in FIG. 2 are the particles 113, and it can be seen from FIG. 2 that the surface of the first transparent conductive layer 103 away from the substrate 100 is provided with a plurality of particles 113 which protrude from the surface of the first transparent conductive layer 103 and function as light-trapping structures.

It should be noted that, a first passivation contact structure on the first region 1201 includes the tunneling layer 101 and the first doped semiconductor layer 102, and a second passivation contact structure located at least on the second region 1202 includes the amorphous silicon layer 104 and the second doped semiconductor layer 105. As such, the back contact solar cell is an HTBC cell, i.e., a heterojunction tunnel oxide passivated contact hybrid passivated back contact photovoltaic cell (abbreviated as HTBC).

The first region 1201 and the second region 1202 on the second surface 120 are provided with two distinct passivation contact structures that differ significantly in material. This results in varying light absorption and utilization efficiencies between the first region 1201 and the second region 1202. Generally, the passivation effect of the amorphous silicon layer 104 on the second region 1202 is superior to that of the tunnel layer 101 on the first region 1201. These multifaceted differences collectively lead to differences in the photoelectric conversion efficiency of the local back contact solar cells corresponding to the first region 1201 and the second region 1202 respectively. Based on the above, the surface of the first transparent conductive layer 103 on the first region 1201 away from the substrate 100 is provided with a plurality of particles 113. with the particles 113, this configuration is conducive to enhancing the light-trapping effect of the first transparent conductive layer 103, allowing more light to irradiate the first region 1201 and to be absorbed and utilized, thereby generating more photogenerated carriers. Meanwhile, with the particles 113, this configuration is conducive to increasing the contact area between a subsequent electrode and the first transparent conductive layer 103, which reduces the contact resistance therebetween, thereby facilitating improvement of carrier collection efficiency by the electrode. In this way, multi-faceted collaboration is conducive to compensating for the differences in photoelectric conversion efficiency between the local back contact solar cells corresponding to the first region 1201 and the second region 1202 respectively, thereby enhancing the overall photoelectric conversion efficiency of the back contact solar cell.

Additionally, with the particles 113, this configuration is conducive to increasing the adhesion between the subsequent electrode and the first transparent conductive layer 103, thereby improving their bonding strength, and enhancing the structural stability of the back contact solar cell.

It should be noted that, the second surface 120 of the substrate 100 is divided into the first region 1201 and the second region 1202 to better describe the arrangement of the first passivation contact structure and the second passivation contact structure on the substrate 100. In some embodiments, the first region 1201 may refer to a region where the first passivation contact structure is disposed on the second surface 120 of the substrate 100, and the second region 1202 may refer to a region where the second passivation contact structure is disposed on the second surface 120 of the substrate 100. It should be noted that, depending on the selected manufacturing process, the second passivation contact structure may not only be located on the second region 1202, but also extend to a portion of the first region 1201 adjacent to the second region 1202, as shown in FIG. 1. In practical applications, the second passivation contact structure may also be located only on the second region.

In other words, in some embodiments, the first region 1201 can refer to a region within the substrate 100 that is directly opposite the first doped semiconductor layer 102 in the first direction X, or may be interpreted as a region where the orthographic projection of the first doped semiconductor layer 102 on the substrate 100 is located. The second region 1202 may refer to at least a portion of a region of the substrate 100 that is directly opposite the second doped semiconductor layer 105 in the first direction X, or may be interpreted as at least a portion of a region where the orthographic projection of the second doped semiconductor layer 105 on the substrate 100 is located.

It should be noted that FIG. 1 only schematically shows three first regions 1201 and two second regions 1202. In practical applications, the first regions and the second regions can be alternatively arranged in a mode that the second surface includes a plurality of first regions and a plurality of second regions, with one first region interposed between every two adjacent second regions and one second region interposed between every two adjacent first regions.

Furthermore, there is no gap between the first region 1201 and the second region 1202 in the example shown in FIG. 1. In practical applications, there may be a gap between the first region and the second region.

The back contact solar cell according to an embodiment of the present disclosure will be described in more detail below with reference to the accompanying drawings.

In some embodiments, with reference to FIG. 1, the substrate 100 is configured to receive incident light and generate photogenerated carriers.

In some embodiments, a material of the substrate 100 may be an elemental semiconductor material. Optionally, the elemental semiconductor material consists of a single element, which, for example, may be silicon or germanium. The elemental semiconductor material may be in a single-crystal state, a polycrystalline state, an amorphous state, or a microcrystalline state (a state possessing both single-crystal and amorphous characteristics, referred to as microcrystalline). For example, the silicon may be at least one of single-crystal silicon, polycrystalline silicon, amorphous silicon, or microcrystalline silicon.

In some other embodiments, the material of the substrate 100 may be compound semiconductor material. Optionally, common compound semiconductor material includes, but are not limited to, silicon germanium, silicon carbide, gallium arsenide, indium gallium, perovskite, cadmium telluride, copper indium selenide, or the like. In yet other embodiments, the substrate 100 may be a sapphire substrate, a silicon-on-insulator substrate, or a germanium-on-insulator substrate.

In some embodiments, with reference to FIG. 1, both the first doped semiconductor layer 102 and the substrate 100 are doped with a first doping element, and the second doped semiconductor layer 105 is doped with a second doping element. The doping types of the first and second doping elements are different from each other.

In some embodiments, the first doping element is an N-type doping element, and the second doping element is a P-type doping element. As such, the substrate 100 may be an N-type substrate, the first doped semiconductor layer 102 may be an N-type doped semiconductor layer, and the second doped semiconductor layer 105 may be a P-type doped semiconductor layer. In other cases, the first doping element is a P-type doping element, and the second doping element is an N-type doping element. As such, the substrate 100 may be a P-type substrate, the first doped semiconductor layer 102 may be a P-type doped semiconductor layer, and the second doped semiconductor layer 105 may be an N-type doped semiconductor layer.

In some embodiments, the N-type doping element may be at least one Group V element such as phosphorus (P), bismuth (Bi), antimony (Sb), or arsenic (As). The P-type semiconductor substrate is doped with a P-type element. The P-type doping element may be at least one Group III element such as boron (B), aluminum (Al), gallium (Ga), or indium (In).

In some embodiments, a material of the first doped semiconductor layer 102 may include doped polysilicon, and a material of the second doped semiconductor layer 105 may include doped amorphous silicon.

In some embodiments, a material of the tunneling oxide 101 may be silicon oxide.

In some embodiments, with reference to FIG. 1 or 2, a size of the particles 113 may be in a range from 1 µm to 4 µm, for example, 1.1 µm, 1.2 µm, 1.3 µm, 1.4 µm, 1.5 µm, 1.6 µm, 1.7 µm, 1.8 µm, 1.9 µm, 2 µm, 2.1 µm, 2.2 µm, 2.3 µm, 2.4 µm, 2.5 µm, 2.6 µm, 2.7 µm, 2.8 µm, 2.9 µm, 3 µm, 3.1 µm, 3.2 µm, 3.3 µm, 3.4 µm, 3.5 µm, 3.6 µm, 3.7 µm, 3.8 µm, or 3.9 µm, among others.

It should be noted that, considering that the wavelength of light absorbed and utilized by the substrate 100 in a back contact cell generally ranges from 300 nm to 1200 nm, the particles 113 at the micrometer scale rather than the nanometer scale is conducive to improving matching between the size of the particles 113 and the wavelength of light that is absorbed and utilized by the substrate 100, enhancing the scattering effect of the particles 113 on the light that is absorbed and utilized by the substrate 100, and thereby improving the light-trapping effect of the first transparent conductive layer 103. It should be noted that, the particles can be considered as being at nanometer scale if their size is below 100 nm. Particles at the nanometer scale provide little to even no gain in the light-trapping effect for the absorbed and utilized light by the substrate.

Meanwhile, the particles 113 at the micrometer scale rather than the nanometer scale is conducive to reducing the specific surface area of the first transparent conductive layer 103, i.e., the ratio of the surface area to the volume of the first transparent conductive layer 103, and thereby reduces the parasitic absorption of light, particularly short-wavelength light, by the first transparent conductive layer 103, thereby preventing a temperature rise in the first transparent conductive layer 103.

Furthermore, compared to nano-sized particles, micron-sized particles 113 are less prone to agglomeration, which is conducive to improving the uniformity distribution of the particles 113 within the first transparent conductive layer 103, enhancing the structural stability of the first transparent conductive layer 103, and thereby enabling substantially consistent light-trapping effects in respective regions of the first transparent conductive layer 103.

In some other embodiments, the size of the particles 113 may be in a range from 4 µm to 10 µm.

It should be noted that, if the size of the particles 113 is greater than 10 µm, an amount of particles 113 that can be arranged per unit area in the first transparent conductive layer 103 may significantly decrease, which is unfavorable for improving the light-trapping effect of the first transparent conductive layer 103. Based on this, the size of the particles 113 is designed to be between 1 µm and 10 µm, which is conducive to the arrangement of an appropriate amount of particles 113 per unit area in the first transparent conductive layer 103, thereby guaranteeing a good light-trapping effect. Specifically, a size of the particles 113 between 1 µm and 4 µm provides the first transparent conductive layer 103 with a better light-trapping effect.

Additionally, the size of the particles 113 may vary depending on their preparation process, which will be described in detail later.

It should be noted that the size of the particles 113 may refer to the diameter of the particles 113 or the length, width, or diagonal length of the orthographic projection pattern of the particles 113 on the substrate 100. In practical applications, the orthographic projection pattern of the particles on the substrate may be an irregular polygon. In such cases, the length, width, or diagonal length of the orthographic projection pattern of the particles on the substrate is not absolute but is artificially defined to characterize the size of the particles. For example, when the orthographic projection pattern of the particles on the substrate is an irregular quadrilateral, the length of the orthographic projection pattern of the particles on the substrate can be defined as the length of the longest side of the irregular quadrilateral, the width of the orthographic projection pattern of the particles on the substrate can be defined as the length of the shortest side of the irregular quadrilateral, and the diagonal length of the orthographic projection pattern of the particles on the substrate can be defined as the length of the longest diagonal of the irregular quadrilateral. It can be understood that the above definition is merely an exemplary explanation, and can be flexibly adjusted as needed.

Furthermore, besides irregular quadrilaterals, the orthographic projection pattern of the particles on the substrate may be in the form of other irregular polygons, circles, or irregular shapes approximating a circle. In such cases, the size of the particles is determined by selecting a plurality of different specific-area regions of the particles and then calculating the average values of the length, width, diagonal, or diameter of the plurality of different specific-area regions, where these specific-area regions can be flexibly defined as needed.

In some embodiments, with reference to FIG. 1 or 2, a distribution density of the particles 113 may be in a range from 2.5 × 10⁶ /cm² to 4.5 × 10⁶ /cm².

In some embodiments, with reference to FIG. 1, the first region 1201 may be a polished surface, and the second region 1202 may be a textured surface.

It should be noted that, since a material of the tunneling layer 101 on the first region 1201 differs from a material of the amorphous silicon layer 104 on the second region 1202, the passivation effect provided by the tunneling layer 101 on the first region 1201 differs from the passivation effect provided by the amorphous silicon layer 104 on the second region 1202. Based on this, configuring the first region 1201 as a polished surface is conducive to improving the film uniformity of the tunneling layer 101 on the first region 1201, ensuring no significant thickness variation across different regions of the tunneling layer 101. This enhances the overall passivation effect of the tunneling layer 101 on the first region 1201, thereby compensating for the difference in passivation effect between the tunneling layer 101 on the first region 1201 and the amorphous silicon layer 104 on the second region 1202, and further improving the film uniformity of the first doped semiconductor layer 102 and its passivation effect on the first region 1201. Additionally, configuring the second region 1202 as a textured surface is conducive to improving light-trapping effects of the second region 1202, thereby further increasing the density of photogenerated carriers, while providing good passivation on the second region 1202 by using the amorphous silicon layer 104.

In some embodiments, with reference to FIG. 1, the material of the particles 113 may be the same as that of the first transparent conductive layer 103.

In some embodiments, the particles 113 may be integrally formed with the first transparent conductive layer 103, which is conducive to improved efficiency and reduced costs for manufacturing both the particles 113 and the first transparent conductive layer 103.

In some embodiments, the materials for both the particles 113 and the first transparent conductive layer 103 may be at least one of tin-doped indium oxide, tungsten-doped indium oxide, cesium-doped indium oxide, cerium-doped indium oxide, tin oxide, gallium-doped zinc oxide, aluminum-doped zinc oxide (AZO), or aluminum zinc oxide.

In some other embodiments, with reference to FIG. 1, the material of the particles 113 may include at least one of silicon oxide, titanium oxide, zinc oxide, or silver nanoparticles, and the material of the first transparent conductive layer 103 may include at least one of tin-doped indium oxide, tungsten-doped indium oxide, cesium-doped indium oxide, cerium-doped indium oxide, tin oxide, gallium-doped zinc oxide, aluminum-doped zinc oxide, or aluminum zinc oxide. In other words, the material of the particles 113 is different from that of the first transparent conductive layer 103.

In the various embodiments described above, the material of the second transparent conductive layer 106 may be the same as that of the first transparent conductive layer 103. This allows the second transparent conductive layer 106 to be fabricated during the process of forming the first transparent conductive layer 103, which is conducive to improved efficiency and reduced costs for manufacturing both the first and second transparent conductive layers.

In some embodiments, the material of the second transparent conductive layer 106 may be at least one of tin-doped indium oxide, tungsten-doped indium oxide, cesium-doped indium oxide, cerium-doped indium oxide, tin oxide, gallium-doped zinc oxide, aluminum-doped zinc oxide, or aluminum zinc oxide.

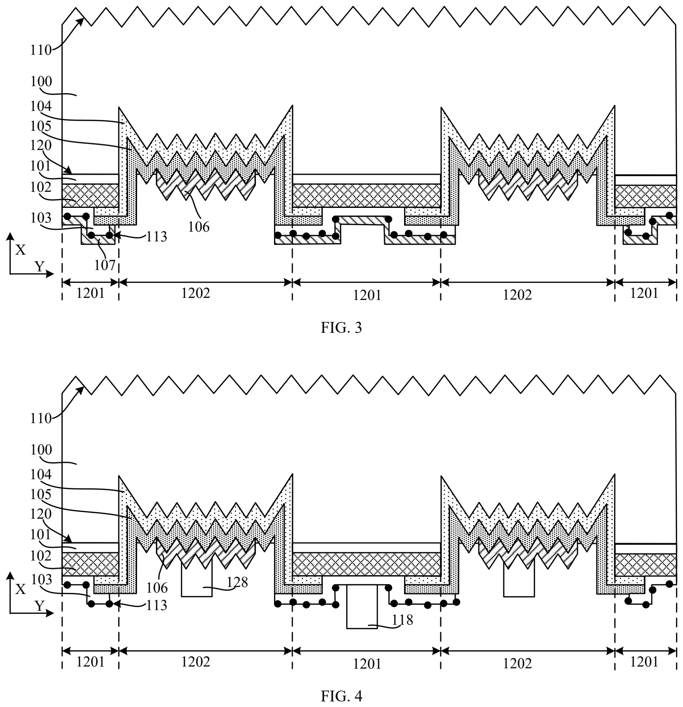

In some embodiments, with reference to FIG. 3, which is schematic partial cross-sectional view of a back contact solar cell according to another embodiment of the present disclosure, the back contact solar cell may further include: a protective layer 107 located on a surface of the first transparent conductive layer 103 away from the substrate 100. It should be noted that, the protective layer 107 is conducive to protecting the surface of the particles 113, preventing them from failure due to subsequent oxidation or damage, thereby ensuring an excellent light-trapping effect of the particles 113; meanwhile, the protective layer 107 may also serve to secure the positions of the particles 113, thereby enhancing the structural stability of the first transparent conductive layer 103; and furthermore, the protective layer 107 may further serve passivation and/or anti-reflection functions, further improving the light utilization efficiency of the first region 1201 and the density of photogenerated carriers generated in the first region 1201.

It should be noted that the protective layer 107 is located not only in the gaps between different particles 113 but also on the surfaces of the particles 113. Additionally, while the protective layer 107 as shown in FIG. 3 is illustrated only on the surface of the first transparent conductive layer 103 away from the substrate 100, in practical applications, a protective layer may be disposed on a surface of the second transparent conductive layer away from the substrate.

In some embodiments, when the particles 113 are silver nanoparticles, the protective layer 107 can prevent isolated silver nanostructures from agglomeration and thus failure, thereby improving the distribution uniformity of the particles 113 in the first transparent conductive layer 103.

In some embodiments, the material of the protective layer 107 may include at least one of silicon oxide, silicon nitride, silicon oxynitride, or aluminum oxide.

In some embodiments, with reference to FIG. 1 or 3, the thickness of the first transparent conductive layer 103 may be greater than that of the second transparent conductive layer 106 in the first direction X.

In some embodiments, the photogenerated carriers generated in the substrate 100 are classed into electrons and holes. The first transparent conductive layer 103 is doped with an N-type doping element and is configured to transport electrons generated in the substrate 100. The first transparent conductive layer 103 can be regarded as an electron transport layer. The second transparent conductive layer 106 is doped with a P-type doping element and is configured to transport holes generated in the substrate 100. The second transparent conductive layer 106 can be regarded as a hole transport layer. Generally, electron mobility is significantly higher than hole mobility.

Based on this, the first transparent conductive layer 103 is designed to be thicker than the second transparent conductive layer 106. A thinner second transparent conductive layer 106 is conducive to reducing the transport path length for holes in the first direction X within the second transparent conductive layer 106, thereby lowering the resistive losses for holes in the second transparent conductive layer 106, and facilitating improved fill factor and reduced series resistance for the back contact solar cell. Meanwhile, a thicker first transparent conductive layer 103 is conducive to reducing the resistance to the lateral transport of electrons in first transparent conductive layer 103, i.e., the resistance to electron transport in the direction perpendicular to the first direction X, ensuring efficient electron collection.

In some embodiments, with reference to FIG. 4, which is schematic partial cross-sectional view of a back contact solar cell according to yet another embodiment of the present disclosure, the back contact solar cell may further include a first electrode 118 located on the first region 1201 and being in contact with and connected to the first transparent conductive layer 103; and a second electrode 128 located on the second region 1202 and being in contact with and connected to the second transparent conductive layer 106. It should be noted that the first electrode 118 may be not in contact with the first doped semiconductor layer 102, and carriers from the first doped semiconductor layer 102 are transported to the first electrode 118 via the first transparent conductive layer 103. The second electrode 128 may be not in contact with the second doped semiconductor layer 105, and carriers from the second doped semiconductor layer 105 are transported to the second electrode 128 via the second transparent conductive layer 106.

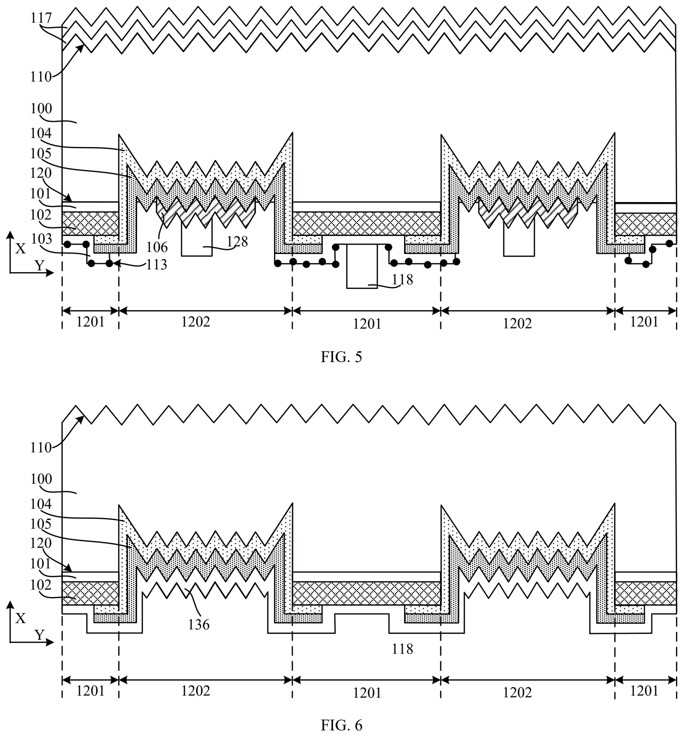

In some embodiments, with reference to FIG. 5, which is schematic partial cross-sectional view of a back contact solar cell according to still another embodiment of the present disclosure, the back contact solar cell may further include a front passivation layer 117 located on the first surface 110 of the substrate 100.

In some embodiments, sill referring to FIG. 5, the front passivation layer 117 may be a laminated structure. For example, the front passivation layer 117 may be a combined film including an aluminum oxide layer and a silicon oxynitride layer, with the aluminum oxide layer being more adjacent to the first surface 110. In other cases, the front passivation layer may be a single-layer structure. For example, the front passivation layer may be a silicon nitride layer.

In some embodiments, referring to FIGS. 1, and 3 to 5, and with the first surface 110 as a reference plane, the second region 1202 is more adjacent to the first surface 110 in the first direction X than the first region 1201. The first direction X refers to the thickness direction of the substrate 100.

In other words, compared to the first region 1201, the second region 1202 is recessed into the substrate 100, so that a surface of most region of the second passivation contact structure away from the substrate 100 is lower than the surface of the first passivation contact structure away from the substrate 100. The first passivation contact structure on the first region 1201 includes the tunneling layer 101 and the first doped semiconductor layer 102. The second passivation contact structure located at least on the second region 1202 includes the amorphous silicon layer 104 and the second doped semiconductor layer 105. As such, it is conducive to further improving light-trapping effect of the second region 1202.

In summary, based on the construction of two distinct passivation contact structures with significantly different materials on the first region 1201 and the second region 1202 of the second surface 120, the surface of the first transparent conductive layer 103 on the first region 1201 away from the substrate 100 is provided with a plurality of particles 113. With the particles 113, this configuration is conducive to enhancing the light-trapping effect of the first transparent conductive layer 103, allowing more light to irradiate the first region and to be absorbed and utilized, and thereby generating more photogenerated carriers. Meanwhile, with the particles 113, this configuration is conducive to increasing the contact area between a subsequent electrode and the first transparent conductive layer 103, which reduces the contact resistance therebetween, thereby facilitating improvement of carrier collection efficiency by the electrode. As such, multi-faceted collaboration is conducive to compensating for the differences in photoelectric conversion efficiency between the local back contact solar cells corresponding to the first region 1201 and the second region 1202 respectively, thereby enhancing the overall photoelectric conversion efficiency of the back contact solar cell.

Additionally, with the particles 113, this configuration is conducive to increasing the adhesion between the subsequent electrode and the first transparent conductive layer 103, thereby improving their bonding strength and enhancing the structural stability of the back contact solar cell.

Another embodiment of the present disclosure further provides a method for manufacturing a back contact solar cell, which is used for manufacturing the back contact solar cell according to the above embodiments. The method for manufacturing a back contact solar cell according to another embodiment of the present disclosure will be described in detail below with reference to the accompanying drawings. It should be noted that the parts that are the same as or corresponding to the foregoing embodiments are not reiterated herein.

With combined reference to FIGS. 1 to 5, a method for manufacturing a back contact solar cell includes: providing a substrate 100 having a first surface 110 and a second surface 120 opposite to each other in a first direction X, wherein the second surface 120 includes a first region 1201 and a second region 1202 alternately arranged in a second direction Y; forming a tunneling layer 101 and a first doped semiconductor layer 102 at least on the first region 1201, wherein the first doped semiconductor layer 102 is located on a surface of the tunneling layer 101 away from the substrate 100; forming an amorphous silicon layer 104 and a second doped semiconductor layer 105 at least on the second region 1202, wherein the second doped semiconductor layer 105 is located on a surface of the tunneling layer 101 away from the substrate 100; and forming a first transparent conductive layer 103 and a second transparent conductive layer 106, wherein the first transparent conductive layer 103 is located on a surface of the first doped semiconductor layer 102 away from the substrate 100, a surface of the first transparent conductive layer 103 away from the substrate 100 is provided with a plurality of particles 113, the second transparent conductive layer 106 is located on a surface of the second doped semiconductor layer 105 away from the substrate 100, and a gap is present between the second transparent conductive layer 106 and the first transparent conductive layer 103.

It should be noted that, forming the first transparent conductive layer 103 having the plurality of particles 113 on a surface thereof away from the substrate 100 is conducive to compensating for the difference in photoelectric conversion efficiency between local back contact solar cells corresponding to the first region 1201 and the second region 1202 respectively, thereby improving the overall photoelectric conversion efficiency of the back contact solar cell. In addition, with the particles 113, it is conducive to enhancing the adhesion between a subsequent electrode and the first transparent conductive layer 103, thereby improving their bonding strength and enhancing the structural stability of the back contact solar cell.

It should be noted that, in the manufacturing method for the back contact solar cell according to another embodiment of the present disclosure, the steps of forming the tunneling layer 101, the first doped semiconductor layer 102, the amorphous silicon layer 104, and the second doped semiconductor layer 105 are not limited. Any current processes suitable for manufacturing the tunneling layer 101, the first doped semiconductor layer 102, the amorphous silicon layer 104, and the second doped semiconductor layer 105 in an HTBC solar cell are applicable to the method for manufacturing the back contact solar cell according to another embodiment of the present disclosure, and are not exhaustively listed in the present disclosure.

The method for forming the first transparent conductive layer 103 and the second transparent conductive layer 106 is described in detail below according to several embodiments.

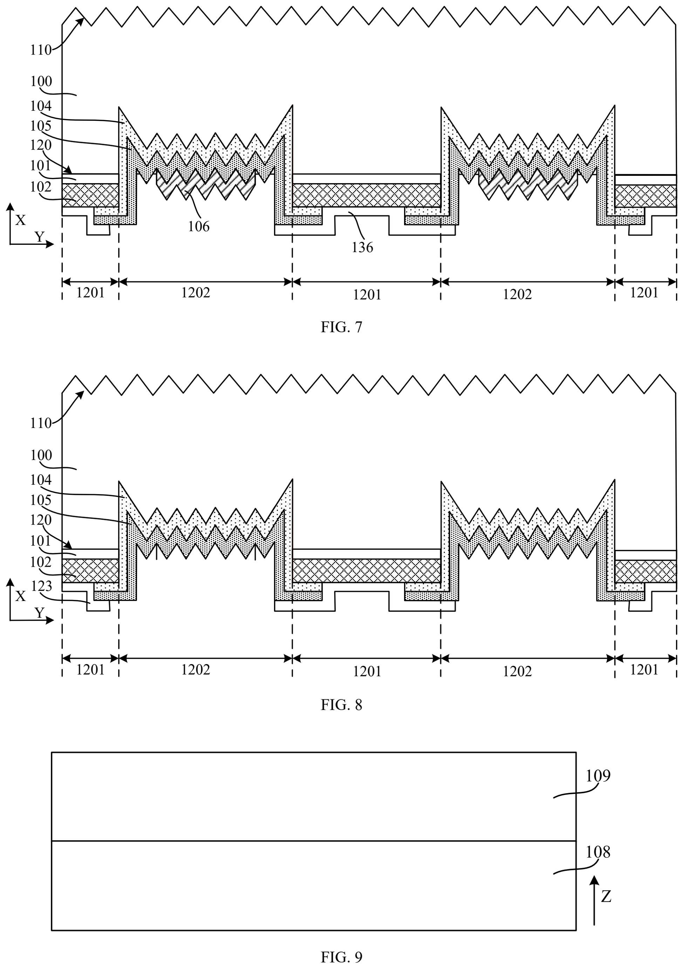

In some embodiments, with reference to FIGS. 6, 7, and 1, the step of forming the first transparent conductive layer 103 and the second transparent conductive layer 106 may include: forming an initial transparent conductive layer 136, wherein the initial transparent conductive layer 136 is located both on a surface of the first doped semiconductor layer 102 located on the first region 1201 away from the substrate 100 and on a surface of the second doped semiconductor layer 105 located on the second region 1202 away from the substrate 100, referring to FIG. 6; performing a grooving process on the initial transparent conductive layer 136 to form a gap between the initial transparent conductive layer 136 located on the first region 1201 and the initial transparent conductive layer 136 located on the second region 1202, referring to FIGS. 6 and 7; and performing a laser treatment on the initial transparent conductive layer 136 located on the first region 1201 to form the particles 113 on a surface of the initial transparent conductive layer 136 located on the first region 1201 away from the substrate 100, referring to FIGS. 7 and 1.

FIG. 6 is a schematic partial cross-sectional view of a back contact solar cell after forming an initial transparent conductive layer in a method for manufacturing a back contact solar cell according to another embodiment of the present disclosure. FIG. 7 is a schematic partial cross-sectional view of a back contact solar cell after performing a grooving process in a method for manufacturing a back contact solar cell according to another embodiment of the present disclosure.

It should be noted that, with reference to FIGS. 6 and 7, after performing a grooving process on the initial transparent conductive layer 136, the remaining portion of the initial transparent conductive layer 136 located on the second region 1202 is the second transparent conductive layer 106. After subsequently performing the laser treatment on the initial transparent conductive layer 136 located on the first region 1201, the first transparent conductive layer 103 located on the first region 1201 and provided with the particles 113 is formed. As such, the second transparent conductive layer 106 can be formed during manufacturing the first transparent conductive layer 103, which is conducive to simplifying the steps for manufacturing the back contact solar cell, and improving the efficiency of forming the first transparent conductive layer 103 and the second transparent conductive layer 106, and reduce their production costs.

In some embodiments, the grooving process may be performed on the initial transparent conductive layer 136 by a laser patterning process or an ink etching process.

In some embodiments, the laser treatment can be performed on the initial transparent conductive layer 136 located on the first region 1201 by a laser scanning process, thereby forming the particles 113 on the surface of the initial transparent conductive layer 136 located on the first region 1201 away from the substrate 100. It should be noted that the laser for the laser scanning process affects not only the initial transparent conductive layer 136 on the first region 1201, but also the first doped semiconductor layer 102 beneath the initial transparent conductive layer 136, which causes an element from the first doped semiconductor layer 102 to diffuse into the initial transparent conductive layer 136, conformally forming the particles 113 together with the initial transparent conductive layer 136.

In some embodiments, the laser wavelength used in the laser treatment may be in a range from 355 nm to 532 nm, for example, 360 nm, 370 nm, 380 nm, 390 nm, 400 nm, 410 nm, 420 nm, 430 nm, 440 nm, 450 nm, 460 nm, 470 nm, 480 nm, 490 nm, 500 nm, 510 nm, 520 nm, 530 nm, etc.

It should be noted that if the laser wavelength used in the laser treatment is less than 355 nm, the laser has relatively weak penetration capability, resulting in less impact on the first doped semiconductor layer 102 beneath the initial transparent conductive layer 136, and is unfavorable for forming an appropriate quantity of particles 113. If the laser wavelength used in the laser treatment exceeds 532 nm, the laser has strong penetration capability, which easily causes laser damage to both the initial transparent conductive layer 136 and the first doped semiconductor layer 102. As such, if the laser wavelength used in the laser treatment is designed to be in a range from 355 nm to 532 nm, it is conducive to forming an appropriate quantity of particles 113 in the initial transparent conductive layer 136 and preventing both the initial transparent conductive layer 136 and the first doped semiconductor layer 102 from laser damage.

In some other embodiments, with reference to FIG. 8 and FIG. 1, where FIG. 8 is a schematic partial cross-sectional view of a back contact solar cell after forming an initial first transparent conductive layer in the method for manufacturing the back contact solar cell according to another embodiment of the present disclosure, the step of forming the first transparent conductive layer 103 may include forming an initial first transparent conductive layer 123 on the surface of the first doped semiconductor layer 102 located on the first region 1201 away from the substrate 100; and etching a surface of the initial first transparent conductive layer 123 away from the substrate 100 to form the first transparent conductive layer 103 having the particles 113.

In some embodiments, with reference to FIG. 8 and FIG. 1, both the step of forming the initial first transparent conductive layer 123 and the step of etching the surface of the initial first transparent conductive layer 123 away from the substrate 100 may be carried out prior to forming the second transparent conductive layer 106. In other words, the second transparent conductive layer 106 is formed after forming the first transparent conductive layer 103 having the particles 113. It should be noted that, in practical applications, the steps of forming the second transparent conductive layer and the initial first transparent conductive layer may be performed simultaneously. For example, an initial transparent conductive layer is first formed, a portion of the initial transparent conductive layer intended to subsequently serve as the second transparent conductive layer is then covered with a masking layer, a portion of the initial transparent conductive layer intended to subsequently serve as the first transparent conductive layer is etched, and a portion of the initial transparent conductive layer located between the first transparent conductive layer and the second transparent conductive layer is removed.

In some embodiments, the step of etching the surface of the initial first transparent conductive layer 123 away from the substrate 100 includes spraying an etching solution onto the surface of the initial first transparent conductive layer 123 away from the substrate 100, and locally etching the surface of the initial first transparent conductive layer 123 away from the substrate 100 with the etching solution to form the particles 113.

In some embodiments, the etching solution may be an acidic solution containing hydrogen chloride and/or ammonium fluoride. A concentration of hydrogen chloride or ammonium fluoride in the etching solution may be in a range from 1% to 10%, for example, 2%, 3%, 4%, 5%, 6%, 7%, 8%, 9%, etc.

In some embodiments, etching the surface of the initial first transparent conductive layer 123 away from the substrate 100 may be performed at a temperature in a range from 25°C to 150°C, for example, 30°C, 40°C, 50°C, 60°C, 70°C, 80°C, 90°C, 100°C, 110°C, 120°C, 130°C, 140°C, etc.

In some embodiments, etching the surface of the initial first transparent conductive layer 123 away from the substrate 100 may be performed for a time period from 30s to 180s, for example, 40s, 50s, 60s, 70s, 80s, 90s, 100s, 110s, 120s, 130s, 140s, 150s, 160s, 170s, etc.

In some other embodiments, with reference to FIG. 8 and FIG. 1, the step of forming the first transparent conductive layer 103 includes forming an initial first transparent conductive layer 123 on the surface of the first doped semiconductor layer 102 located on the first region 1201 away from the substrate 100, and forming particles 113 on a surface of the initial first transparent conductive layer 123 away from the substrate 100. The particles 113 are located on the surface of the initial first transparent conductive layer 123 away from the substrate 100, or the particles 113 is partially embedded in the initial first transparent conductive layer 123. The particles 113 and the initial first transparent conductive layer 123 together constitute the first transparent conductive layer 103.

It should be noted that the particles 113 may be formed on the surface of the initial first transparent conductive layer 123 away from the substrate 100 by a coating process or a deposition process. The coating process exerts a certain pressure on the initial first transparent conductive layer 123, which may cause some particles 113 to be partially embedded in the initial first transparent conductive layer 123.

Another embodiment of the present disclosure further provides a tandem solar cell. The tandem solar cell includes the photovoltaic cell according to the above embodiments or a photovoltaic cell formed by the method according to the above embodiments. The tandem solar cell according to yet another embodiment of the present disclosure will be described in detailed with reference to the accompanying drawings. It should be noted that the parts that are the same as or corresponding to the foregoing embodiments are not reiterated herein.

With reference to FIG. 9, which is a schematic partial cross-sectional view of a tandem solar cell according to yet another embodiment of the present disclosure, the tandem solar cell includes: a bottom solar cell 108, which is the photovoltaic cell according to the above embodiments or a photovoltaic cell formed by the method according to the above embodiments; and a top solar cell 109 located on a side of the bottom solar cell 108.

In some embodiments, the top solar cell 109 may be one of a perovskite solar cell, a donor-acceptor cell, a cadmium telluride (CdTe) photovoltaic cell, a copper indium gallium selenide (CIGS) photovoltaic cell, and a gallium arsenide (GaAs) photovoltaic cell.

In some embodiments, the top solar cell 109 may include a first transport layer, a perovskite substrate, a second transport layer, a transparent conductive layer, and an anti-reflection layer which are stacked. The first transport layer directly faces the bottom solar cell 108.

In some embodiments, the first transport layer may be one of an electron transport layer or a hole transport layer, and the second transport layer may be the other of the electron transport layer or the hole transport layer.

In some embodiments, a bandgap of the top solar cell 109 is wider than that of the bottom solar cell 108. Therefore, stacking the top solar cell 109 on the bottom solar cell 108 enables the tandem solar cell to have a broader spectral response range, thereby maximizing solar energy utilization and improving the efficiency of the photovoltaic cell.

In some embodiments, the back contact tandem solar cell may further include an intermediate connection layer (not shown), which is connected between the bottom solar cell 108 and the top solar cell 109.

In some embodiments, the intermediate connection layer is generally a tunneling junction or a thin composite layer of metal or a transparent electrode. Optionally, the intermediate connection layer may be a transparent conductive oxide. The transparent conductive oxide exhibits excellent photoelectrical properties, high photon transmittance, and high conductivity, thereby enabling good ohmic contact between the top solar cell 109 and the bottom solar cell 108.

In other cases, the back finger gridlines, back main gridlines, front finger gridlines, and front main gridlines in the photovoltaic cell serving as the bottom solar cell 108 may also function as the intermediate connection layer to achieve electrical connection with the top solar cell 109.

A photovoltaic module is further provided according to yet another embodiment of the present disclosure. The photovoltaic module includes a plurality of photovoltaic cells according to the above embodiments connected with each other, or a plurality of photovoltaic cells formed by the method according to the above embodiments connected with each other, or a plurality of tandem solar cells according to the above embodiments connected with each other. The photovoltaic module is configured to convert received light energy into electrical energy. It should be noted that the parts that are the same as or corresponding to the foregoing embodiments may refer to the corresponding descriptions in the aforementioned embodiments, which will not be reiterated herein.

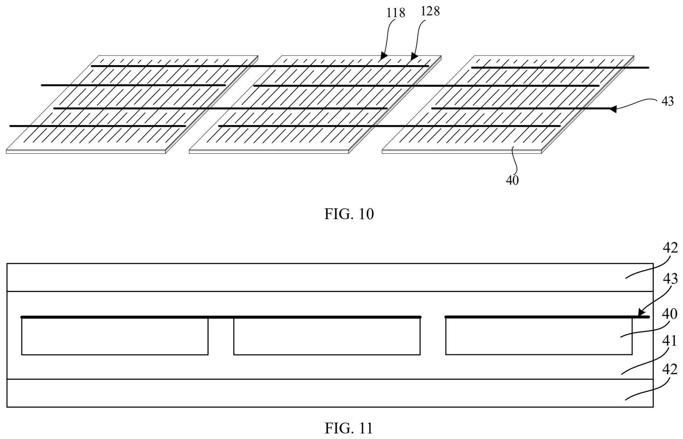

With reference to FIGS. 10, 11, and 1 to 9, the photovoltaic module includes: a solar cell string formed by electrically connecting a plurality of back contact solar cells 40 according to the above embodiments, or formed by electrically connecting a plurality of back contact solar cells 40 formed by the method for manufacturing the photovoltaic cells according to the above embodiments, or formed by electrically connecting a plurality of tandem solar cells according to the above embodiments; a encapsulation adhesive film 41 configured to cover the surface of the solar cell string; and a cover plate 42 configured to cover a surface of the encapsulation adhesive film 41 away from the solar cell string.

FIG. 10 is a schematic partial three-dimensional view of a solar cell string in a photovoltaic module according to yet another embodiment of the present disclosure. FIG. 11 is a schematic partial cross-sectional view of a photovoltaic module according to yet another embodiment of the present disclosure.

In some embodiments, the back contact solar cells 40, which can be complete whole cells or sliced cells, are electrically connected to form a plurality of solar cell strings. The plurality of solar cell strings are electrically connected in series and/or parallel. The back contact solar cell 40 can be a complete whole cell, or a sliced cell which refers to a cell formed by cutting a complete whole cell using a cutting process.

In some embodiments, with reference to FIG. 10 or 11, a plurality of back contact solar cells 40 can be electrically connected via conductive strips 43. FIGS. 10 and 11 only illustrate a possible positional relationship between the back contact solar cells 40. In practical applications, the gridlines of adjacent back contact solar cells may be located on different sides, in which case two adjacent back contact solar cells are connected at different sides by the conductive strip.

In some embodiments, the encapsulation adhesive film 41 includes a first encapsulating layer and a second encapsulating layer. The first encapsulating layer covers one of the front surface and the back surface of the back contact solar cell 40, and the second encapsulating layer covers the other of front surface and the back surface of the back contact solar cell 40. Specifically, at least one of the first encapsulating layer or the second encapsulating layer may be an organic encapsulation adhesive film such as a polyvinyl butyral (PVB) adhesive film, an ethylene-vinyl acetate copolymer (EVA) adhesive film, a polyolefin elastomer (POE) adhesive film, or a polyethylene terephthalate (PET) adhesive film. Alternatively, at least one of the first encapsulating layer or the second encapsulating layer may be an EP adhesive film, an EPE adhesive film, or a PVP adhesive film. Herein, the EP adhesive film refers to a co-extruded adhesive film formed by an EVA adhesive film and a POE adhesive film in laminated arrangement; an EPE adhesive film refers to a co-extruded adhesive film formed by an EVA adhesive film, a POE adhesive film, and an EVA adhesive film laminated in sequence; a PVP adhesive film refers to a co-extruded adhesive film formed by a POE adhesive film, an EVA adhesive film, and a POE adhesive film in laminated arrangement. The method for preparing the co-extruded adhesive film can involve extruding one or more materials onto another pre-formed adhesive film during the adhesive film processing, or bonding different types of pre-formed adhesive films together.

In some embodiments, the first encapsulating layer and the second encapsulating layer has a distinct boundary prior to lamination. After the lamination to form the photovoltaic module, the concept of the first encapsulating layer and the second encapsulating layer no longer exists. That is, the first encapsulating layer and the second encapsulating layer have been formed an integrated encapsulation adhesive film 41.

In some embodiments, the cover plate 42 may be a cover plate with a light-transmitting function such as a glass cover plate or a plastic cover plate. Specifically, a surface of the cover plate 42 facing the encapsulation adhesive film 41 may be a surface with concave and convex structures or a textured surface including a plurality of protruding structures, thereby increasing a utilization rate of incident light. The cover plate 42 includes a first cover plate and a second cover plate. The first cover plate corresponds to the first encapsulating layer, and the second cover plate corresponds to the second encapsulating layer.

## Claims

1. A back contact solar cell (40), comprising:
a substrate (100) having a first surface (110) and a second surface (120) opposite to each other in a first direction, the second surface (120) comprising a first region (1201) and a second region (1202) alternately arranged in a second direction;
a tunneling layer (101), at least located on the first region (1201);
a first doped semiconductor layer (102) located on a surface of the tunneling layer (101) away from the substrate (100);
a first transparent conductive layer (103) located on a surface of the first doped semiconductor layer (102) away from the substrate (100), a surface of the first transparent conductive layer (103) away from the substrate (100) being provided with a plurality of particles (113);
an amorphous silicon layer (104), at least located on the second region (1202);
a second doped semiconductor layer (105), located on a surface of the amorphous silicon layer (104) away from the substrate (100); and
a second transparent conductive layer (106), located on a surface of the second doped semiconductor layer (105) away from the substrate (100), a gap being present between the second transparent conductive layer (106) and the first transparent conductive layer (103).

2. The back contact solar cell (40) according to claim 1, wherein the particles (113) have a size of 1 µm to 4 µm.

3. The back contact solar cell (40) according to claim 1 or 2, wherein the particles (113) have a distribution density of 2.5 X 10⁶ /cm² to 4.5 × 10⁶ /cm².

4. The back contact solar cell (40) according to any one of claims 1 to 3, wherein the first region (1201) is a polished surface, and the second region (1202) is a textured surface.

5. The back contact solar cell (40) according to any one of claims 1 to 4, wherein a material of the particles (113) is the same as a material of the first transparent conductive layer (103); or
the material of the particles (113) comprises at least one of silicon oxide, titanium oxide, zinc oxide, or silver nanoparticles, and the material of the first transparent conductive layer (103) comprises at least one of tin-doped indium oxide, tungsten-doped indium oxide, cesium-doped indium oxide, cerium-doped indium oxide, tin oxide, gallium-doped zinc oxide, aluminum-doped zinc oxide, or aluminum zinc oxide.

6. The back contact solar cell (40) according to any one of claims 1 to 5, further comprising a protective layer (107) located on a surface of the first transparent conductive layer (103) away from the substrate (100).

7. The back contact solar cell (40) according to any one of claims 1 to 6, wherein in the first direction, a thickness of the first transparent conductive layer (103) is greater than a thickness of the second transparent conductive layer (106).

8. The back contact solar cell (40) according to any one of claims 1 to 7, wherein both the first doped semiconductor layer (102) and the substrate (100) are doped with a first doping element, and the second doped semiconductor layer (105) is doped with a second doping element, a doping type of the first doping element being different from a doping type of the second doping element; and/or a material of the first doped semiconductor layer (102) comprises doped polysilicon, and a material of the second doped semiconductor layer (105) comprises doped amorphous silicon.

9. A method for manufacturing a back contact solar cell (40), comprising:
providing a substrate (100), the substrate (100) having a first surface (110) and a second surface (120) opposite to each other in a first direction, the second surface (120) comprising a first region (1201) and a second region (1202) alternately arranged in a second direction;
forming a tunneling layer (101) and a first doped semiconductor layer (102) at least on the first region (1201), the first doped semiconductor layer (102) being located on a surface of the tunneling layer (101) away from the substrate (100);
forming an amorphous silicon layer (104) and a second doped semiconductor layer (105) at least on the second region (1202), the second doped semiconductor layer (105) being located on a surface of the tunneling layer (101) away from the substrate (100); and
forming a first transparent conductive layer (103) and a second transparent conductive layer (106);
wherein the first transparent conductive layer (103) is located on a surface of the first doped semiconductor layer (102) away from the substrate (100), a surface of the first transparent conductive layer (103) away from the substrate (100) is provided with a plurality of particles (113), the second transparent conductive layer (106) is located on a surface of the second doped semiconductor layer (105) away from the substrate (100), and a gap is present between the second transparent conductive layer (106) and the first transparent conductive layer (103).

10. The method according to claim 9, wherein the step of forming the first transparent conductive layer (103) and the second transparent conductive layer (106) comprises:
forming an initial transparent conductive layer (136) located both on a surface of the first doped semiconductor layer (102) located on the first region (1201) away from the substrate (100) and on a surface of the second doped semiconductor (105) located on the second region (1202) layer away from the substrate (100);
performing a grooving process on the initial transparent conductive layer (136) to form a gap between the initial transparent conductive layer (136) located on the first region (1201) and the initial transparent conductive layer (136) located on the second region (1202); and
performing a laser treatment on the initial transparent conductive layer (136) located on the first region (1201) to form the particles (113) on the surface of the initial transparent conductive layer (136) located on the first region (1201) away from the substrate (100).

11. The method according to claim 10, wherein a laser used in the laser treatment has a wavelength of 355 nm to 532 nm.

12. The method according to any one of claims 9 to 11, wherein the step of forming the first transparent conductive layer (103) comprises:
forming an initial first transparent conductive layer (123) on the surface of the first doped semiconductor layer (102) located on the first region (1201) away from the substrate (100); and
etching the surface of the initial first transparent conductive layer (123) away from the substrate (100) to form the first transparent conductive layer (103) with the particles (113).

13. The method according to any one of claims 9 to 11, wherein the step of forming the first transparent conductive layer (103) comprises:
forming an initial first transparent conductive layer (123) on the surface of the first doped semiconductor layer (102) located on the first region (1201) away from the substrate (100); and
forming the particles (113) on a surface of the initial first transparent conductive layer (123) away from the substrate (100),
wherein the particles (113) are located on the surface of the initial first transparent conductive layer (123) away from the substrate (100), or a portion of the particles (113) are embedded in the initial first transparent conductive layer (123), and the particles (113) and the initial first transparent conductive layer (123) collectively constitute the first transparent conductive layer (103).

14. A tandem solar cell comprising:
a bottom solar cell (108), the bottom solar cell (108) being the back contact solar cell (40) according to any one of claims 1 to 8, or a back contact solar cell (40) formed by the method according to any one of claims 9 to 13; and a top solar cell (109) located on a side of the bottom solar cell (108).

15. A photovoltaic module comprising:
a solar cell string formed by connecting a plurality of the back contact solar cells (40) according to any one of claims 1 to 8, or formed by connecting a plurality of back contact solar cells (40) formed by the method according to any one of claims 9 to 13, or formed by connecting a plurality of the tandem solar cells according to claim 14;
an encapsulation adhesive film (41) configured to cover a surface of the solar cell string; and
a cover plate (42) configured to cover a surface of the encapsulation adhesive film (41) away from the solar cell string.
